(19) Europäisches Patentamt
European Patent Office
Office européen des brevets

(11) **EP 1 033 738 A1**

(12) **EUROPÄISCHE PATENTANMELDUNG**

(43) Veröffentlichungstag:
06.09.2000 Patentblatt 2000/36

(51) Int. Cl.[7]: **H01J 3/30**, H01J 37/147

(21) Anmeldenummer: **00100314.4**

(22) Anmeldetag: **07.01.2000**

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **24.02.1999 DE 19907858**

(71) Anmelder:
**Leica Microsystems Lithography GmbH
07745 Jena (DE)**

(72) Erfinder:
• **Döring, Hans-Joachim
07749 Jena (DE)**
• **Elster, Thomas
07745 Jena (DE)**

(74) Vertreter:
**Reichert, Werner F., Dr.
Leica Microsystems International Holdings GmbH,
Konzernstelle Patente + Marken,
Postfach 20 20
35530 Wetzlar (DE)**

(54) **Vorrichtung zur elektrostatischen Ablenkung eines Korpuskularstrahles**

(57)    Die Erfindung bezieht sich auf eine Vorrichtung zur elektrostatischen Ablenkung eines Korpuskularstrahles aus einer Primärstrahlungsrichtung (4) zum Zweck der Abtastung einer von zwei Koordinaten X,Y aufgespannten Ebene, bei der mehrere in Form von Ablenkdrähten (2) ausgebildete Elektroden mit einer Ansteuerschaltung (5) verbunden und je nach Ansteuerung mit veränderbaren Ablenkspannungen beaufschlagt sind; die Primärstrahlungsrichtung (4) schneidet dabei den Ursprung der Koordinaten X,Y und die jeweils anliegende Ablenkspannung ist ein Äquivalent für die Ablenkung des Korpukularstrahles aus der Primärstrahlungsnichtung (4) in Richtung der Koordinate X bzw. der Koordinate Y.

Bei einer solchen Vorrichtung sind die Ablenkdrähte (2) zu Ablenkgittern verknüpft und dabei so miteinander und mit der Ansteuerschaltung (5) verbunden, daß bei allen zu einem Ablenkgitter gehörenden Ablenkdrähten (2.11, 2.12; 2.21, 2.22; 2.31, 2.32) stets eine gleichwertige Ablenkspannung anliegt.

Fig.3

**Beschreibung**

Die Erfindung bezieht sich auf eine Vorrichtung zur elektrostatischen Ablenkung eines Korpuskularstrahles aus einer Primärstrahlungsrichtung zum Zweck der Abtastung einer von zwei Koordinaten X,Y aufgespannten Ebene, bei der mehrere als Ablenkdrähte ausgebildete Elektroden mit einer Ansteuerschaltung verbunden und je nach Ansteuerung mit veränderbaren Ablenkspannungen beaufschlagt sind. Als Primärstrahlungsrichtung ist dabei die Richtung des nicht abgelenkten, den Ursprung der Koordinaten X,Y schneidenden Korpuskularstrahles zu verstehen; die Ablenkspannungen sind ein Äquivalent für die Ablenkung des Korpukularstrahles aus der Primärstrahlungsrichtung in Richtung der Koordinate X bzw. der Koordinate Y.

In Korpuskularstrahlgeräten, so beispielsweise in Elektronenstrahl- wie auch Ionenstrahlbelichtungsanlagen zur Belichtung von Wafern, sind Vorrichtungen zur Ablenkung der Korpuskularstrahlung über die zu belichtende Fläche hinweg erforderlich.

Bei derartigen Ablenkvorrichtungen, die häufig auch als Ablenksysteme bezeichnet werden, erfolgt die Richtungsänderung des Korpuskularstrahles prinzipiell durch Einfluß magnetischer oder elektrostatischer Kräfte. Es sind auch Ablenkvorrichtungen bekannt, bei denen in Strahlungsrichtung nacheinander beide Prinzipien zur Anwendung kommen.

Soll die Ablenkung des Korpuskularstrahles schnell und genau erfolgen, werden elektrostatische Ablenksysteme bevorzugt. Bei derartigen Systemen werden mehrere Ablenkelektroden mit unterschiedlichen Spannungspotentialen beaufschlagt, wodurch ein elektrostatisches Feld erzeugt wird, das je nach Änderung der Spannungspotentiale bzw. je nach Ansteuerung der Ablenkelektroden richtungsändernd auf den Korpuskularstrahl einwirkt. Die Ansteuerung wird so vorgenommen, daß der Korpuskularstrahl aus einer Primärstrahlungsrichtung (die dem nicht abgelenkten Strahlengang entspricht) in eine gewünschte Richtung abgelenkt und in Abhängigkeit von der Variation der Ansteuerung über eine von den Koordinaten X, Y aufgespannte Ebene geführt wird.

In jüngerer Zeit wurden elektrostatische Ablenksysteme entwickelt, bei denen die Ablenkelektroden in Form von Drähten ausgebildet sind, die über eine Teilstrecke parallel zur Primärstrahlungsrichtung verlaufen. Ein solches Ablenksystem ist in DE 31 38 898 A1 beschrieben. Hier ist eine Anzahl von acht Drähten radialsymmetrisch um die Primärstrahlungsrichtung verteilt. Die Drähte sind dabei mit ihren Enden an Isolierkörpern befestigt. Die Befestigungspositionen an den Isolierkörpern bestimmen Lage und Ausrichtung der Drähte relativ zum Korpuskularstrahl. Die in DE 31 38 898 A1 offenbarte Anordnung der Drähte in Bezug auf die Primärstrahlungsrichtung ist in Fig.1 der vorliegenden Beschreibung wiedergegeben.

Ein Nachteil dieser Vorrichtung gegenüber vorher bekannten Ablenksystemen, bei denen Elektroden in Form von Zylinder- oder Kreissegmenten um die Primärstrahlungsrichtung verteilt angeordnet waren, besteht darin, daß eine geringere Ablenk-Empfindlichkeit zu verzeichnen und außerdem auch ein erhöhter Aufwand bei der Ansteuerung der Elektroden zu treiben ist, da gemischte Ablenkpotentiale erzeugt werden müssen (vgl. Seite 4 DE 31 38 898 A1, Zeilen 5 bis 7). Die gemischten Ablenkpotentiale, wie z.B. $U_4=(U_y+U_x)/\sqrt{2}$, sind erforderlich, damit das elektrostatische Feld zumindest etwa homogen wird.

Das beschriebene Draht-Ablenksystem weist demnach geringere Gebrauchswerteigenschaften auf als der vorbekannte Stand der Technik. Dadurch kann dessen eigentlicher Vorteil, nämlich die einfache Herstellbarkeit, insbesondere für die Anwendungsfälle nicht wirksam genutzt werden, bei denen eine schnelle und genaue Ablenkung des Korpuskularstrahles gewünscht ist.

Davon ausgehend liegt der Erfindung die Aufgabe zugrunde, Ablenksysteme der vorbeschriebenen Art dahingehend weiterzubilden, daß unter Beibehaltung der fertigungstechnologischen Vorteile die Gebrauchswerteigenschaften verbessert werden.

Erfindungsgemäß sind bei derartigen Ablenksystemen mehrere Ablenkdrähte zu Ablenkgittern verknüpft, wobei die Ablenkdrähte so miteinander und mit der Ansteuerschaltung verbunden sind, daß bei allen zu einunddemselben Ablenkgitter gehörenden Ablenkdrähten stets eine gleichwertige Ablenkspannung anliegt.

In einer bevorzugten Ausgestaltung der Erfindung ist vorgesehen, daß mehrere Ablenkgitter der Koordinate X zugeordnet und die Ablenkdrähte dieser Ablenkgitter symmetrisch zur Koordinate Y angeordnet sind und/oder daß mehrere Ablenkgitter der Koordinate Y zugeordnet und die Ablenkdrähte dieser Ablenkgitter symmetrisch zur Koordinate X angeordnet sind.

Damit konnte vorteilhaft auch ohne aufwendige Bereitstellung gemischter Ablenkpotentiale eine hohe Feldhomogenität erreicht werden. Außerdem ist es gelungen, durch geeignete Positionierung mehrerer Ablenkdrähte, die im folgenden noch erläutert wird, die Fourierharmonischen des elektrostatischen Potentials höherer Ordnung auf einfache Weise zu unterdrücken und so die Feldhomogenität noch weiter zu verbessern. Die Beaufschlagung mehrerer Ablenkdrähte mit demselben Potential hat vorteilhaft zu einer erhöhten Ablenkempfindlichkeit des gesamten Ablenksystems geführt.

Eine besonders bevorzugte Ausgestaltung der Erfindung sieht vor, daß der Koordinate X und der Koordinate Y jeweils zwei Ablenkgitter zugeordnet sind. Die der Koordinate X zugeordneten Ablenkgitter stehen sich symmetrisch zur Koordinate Y, die der Koordinate Y zugeordneten Ablenkgitter stehen sich symmetrisch zur Koordinate X gegenüber. Dabei ist zwischen den der Koordinate X zugeordneten Ablenkgittern ein Spannungspotential $\pm U_X$ und zwischen den der Koordinate Y zugeordneten Ablenkgittern ein Spannungspotential $\pm U_Y$ vorgesehen. In Abhängigkeit von der Variation der an den Ablenkgittern anliegenden Spannung wird die Ablenkung des Korpuskularstrahles aus der Primärstrahlungsrichtung bewirkt.

In weiteren Ausgestaltungen der Erfindung sind mindestens zwei Ablenkdrähte einunddesselben Ablenkgitters in unterschiedlichen Abständen zum Ursprung der Koordinaten X,Y angeordnet. Mit anderen Worten, die Abstände zwischen den Ablenkdrähten und dem nicht abgelenkten Korpuskularstrahl sind bei mindestens zwei Ablenkdrähten eines Ablenkgitters unterschiedlich groß. Diesbezüglich kann vorteilhaft vorgesehen sein, daß die Querschnittsmittelpunkte aller Ablenkdrähte auf Umfangslinien mehrerer konzentrischer Kreise $k_1$, $k_2$ bis $k_n$ verteilt sind, wobei diese Kreise auch zum Koordinatenursprung bzw. zum nicht abgelenkten Korpuskularstrahl konzentrisch ausgerichtet sind. Auf diese Weise sind die Abstände der Ablenkdrähte, die zu einunddemselben Ablenkgitter gehören, zum nicht abgelenkten Korpuskularstrahl mit den Radien $r_1$, $r_2$ bis $r_n$ der Kreise $k_1$, $k_2$ bis $k_n$ festgelegt.

Eine im Hinblick auf die Feldhomogenität besonders günstige Ausgestaltung ergibt sich beispielhaft dann, wenn insgesamt vier Ablenkgitter vorgesehen sind, jedes Ablenkgitter aus sechs Ablenkdrähten gebildet ist, die Ablenkdrähte aller Ablenkgitter auf Umfangslinien dreier Kreise $k_1$, $k_2$, $k_3$ mit den Radien $r_1 < r_2 < r_3$ verteilt angeordnet sind und dabei jeder der Kreise $k_1$, $k_2$ und $k_3$ mit jeweils zwei Ablenkdrähten eines Gitters besetzt ist.

Dabei sollte das Verhältnis der Radien $r_1$: $r_2$: $r_3$ etwa 1:1,1:1,21 betragen. Die Bogenlänge $b_1$ zwischen den beiden Ablenkdrähten eines Gitters auf dem Kreis $k_1$, die Bogenlänge $b_2$ zwischen den beiden Ablenkdrähten eines Gitters auf dem Kreis $k_2$ und die Bogenlänge $b_3$ zwischen den beiden Ablenkdrähten eines Gitters auf dem Kreis $k_3$ sollten sich zueinander verhalten wie 8: 1: 14.

Dabei ist es von Vorteil, die Bogenlänge $b_1$ innerhalb des Wertebereiches von 5 mm und 10 mm auszuführen. Die Ablenkspannungen $\pm U_X$ und $\pm U_Y$ sollten im Wertebereich bis $\pm 100$ Volt liegen.

Damit wurden insbesondere bei Anwendungen in der Elektronenstrahllithographie sehr gute Ergebnisse in Bezug auf Feldhomogenität und Ablenkempfindlichkeit erreicht. Die Feldinhomogenitäten, in einem Schnitt senkrecht zum nichtabgelenkten Korpuskularstrahl betrachtet, werden bei dieser Ausgestaltung optimal unterdrückt, insbesondere werden die Fourierharmonischen des elektrostatischen Potentials zweiter bis siebenter Ordnung gegen „null" reduziert.

Selbstverständlich können auch andere Verhältniswerte und Größenordnungen gewählt werden, womit dann natürlich abweichende Ergebnisse erzielt werden. Weiterhin ist es auch denkbar, als Basis für die Grundstruktur der Anordnung der Ablenkdrähte nicht oder nicht ausschließlich Umfangslinien von Kreisen zu wählen, sondern andere geometrische Figuren zugrunde zu legen, etwa Quadrate, Achtecke und ähnlich. Funktionswesentlich ist dabei stets, daß die Ablenkdrähte auf diesen Umfangslinien symmetrisch zur Koordinatenachse X und/oder symmetrisch zur Koordinatenachse Y anzuordnen sind.

Als Material für die Ablenkdrähte ist bevorzugt Gold, Platin, Wolfram, Aluminium oder Kupfer oder auch eine Legierung eines oder mehrerer dieser Metalle mit Silizium vorzusehen. Die Durchmesser der Ablenkdrähte sollten zwischen 10 μm und 200 μm betragen.

Neben der vorteilhaften Wirkung im Hinblick auf die Verbesserung der Feldhomogenität und auf die Erhöhung der Ablenkempfindlichkeit sind wegen des einfachen Aufbaues auch gute technologische Voraussetzungen für eine hohe Fertigungsgenauigkeit einer solchen Ablenkvorrichtung gegeben.

Die erfindungsgemäße Ablenkvorrichtung ist vorzugsweise für Geräte zur Erzeugung belichteter Strukturen auf Wafern oder Masken im Halbleiter-Fertigungsprozeß nutzbar. Hierbei kommt besonders vorteilhaft zur Geltung, daß die Ablenkdrähte der verwendeten korpuskular-optischen Belichtungsstrahlung eine geringe Oberfläche bieten, so daß Aufladungen, die zu einer unerwünschten Beeinflussung der Korpuskularstrahlungsrichtung führen könnten, weitestgehend unterdrückt werden.

Vorteilhaft kommt außerdem hinzu, daß die durch Beauflagung eines Ablenkdrahtes mit der jeweiligen Ablenkspannung entstehende Feldstärke aufgrund der verhältnismäßig kleinen Drahtoberfläche hoch ist, wodurch unerwünschte Aufladungen rasch wieder abgebaut werden.

Ein weiterer wesentlicher Vorteil der erfindungsgemäßen Anordnung besteht darin, daß durch die Vielzahl von Ablenkdrähten Spannungspotentiale, die von außen auf das Ablenksystem gerichtet sind, bezüglich ihrer Wirkung auf den Korpuskularstrahl weitestgehend abgeschirmt werden.

Aufgrund der breiten Variationsmöglichkeiten bezüglich der Anordnung der dünnen Drähte können korpuskular-optische Aberrationen wesentlich besser unterdrückt werden, als das bei bekannten Lösungen mit wenigen Ablenkelektroden der Fall ist. So werden mit einem erfindungsgemäßen Ablenksystem, das vierundzwanzig Ablenkdrähte aufweist, die Inhomogenitäten des elektrostatischen Feldes in der Schnittebene senkrecht durch die Primärstrahlungsrichtung aus den bereits dargestellten Gründen optimal unterdrückt.

Wichtig bei der Herstellung der erfindungsgemäßen Vorrichtung ist, daß die Lageabweichungen der Ablenkdrähte von ihrer vorgegebenen Position gering gehalten werden, damit auch die durch Lageungenauigkeiten verursachten Aberrationen eine in Bezug auf die Qualität der optischen Abbildung vernachlässigbare Größe annehmen. Das aber ist dank der Unkompliziertheit der Baugruppen leicht zu bewerkstelligen.

Die Erfindung soll nachfolgend anhand eines Ausführungsbeispieles näher erläutert werden. In den zugehörigen Zeichnungen zeigen

Fig.1 den Stand der Technik
Fig.2 die erfindungsgemäße Anordnung in einer Prinzipdarstellung,
Fig.3 die Anordnung der Drahtquerschnitte in einem Schnitt senkrecht zur Primärstrahlungsrichtung,
Fig.4 die Ausbildung eines elektrostatischen Feldes beim Betreiben der erfindungsgemäßen Vorrichtung.

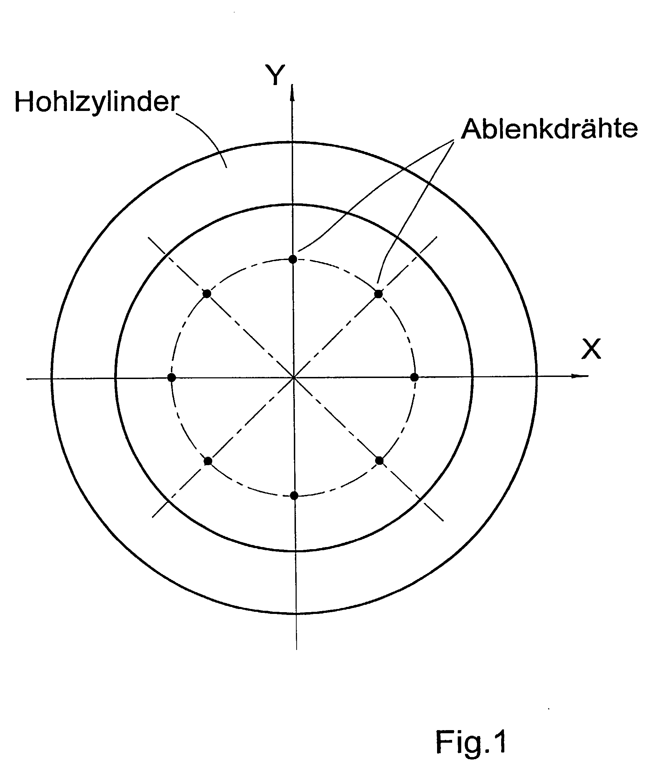

Eine Erläuterung zu Fig. 1, die eine Anordnung von Ablenkdrähten nach dem Stand der Technik darstellt, ist bereits in der Beschreibungseinleitung enthalten, so daß eine Wiederholung hier nicht erforderlich ist.

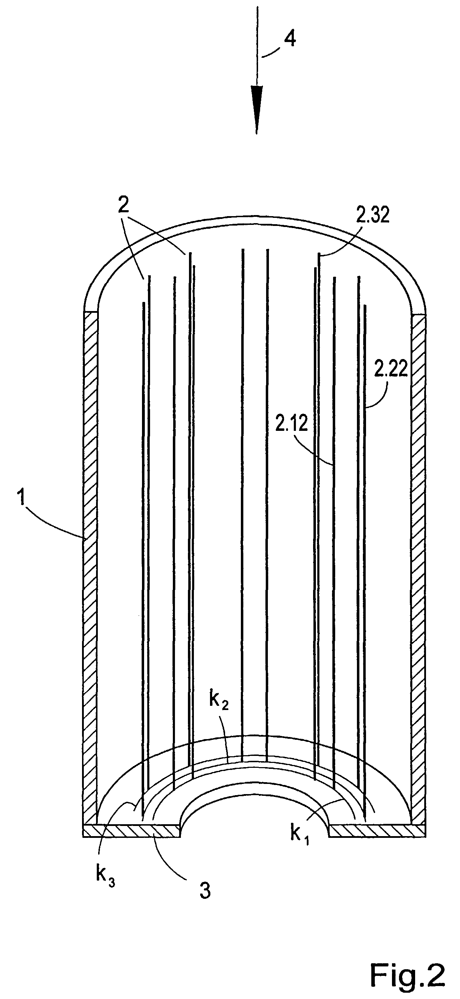

In Fig.2, einer Prinzipdarstellung der erfindungsgemäßen Anordnung, sind innerhalb eines Hohlzylinders 1, der vorzugsweise aus einem elektrisch nichtleitenden Material gefertigt und an seiner Innenfläche mit einem elektrisch leitfähigen Material beschichtet ist, Ablenkdrähte 2 gespannt. Die Enden der Ablenkdrähte 2 sind dabei mit Isolierplatten verbunden, von denen in Fig.2 der Übersichtlichkeit halber lediglich die Isolierplatte 3 dargestellt ist. Jeder der Ablenkdrähte 2 ist mit einem seiner Enden an der Isolierplatte 3 befestigt. Mit ihrem anderen Ende sind die Ablenkdrähte 2 mit der zweiten, nicht dargestellten Isolierplatte, die sich am entgegengesetzten Ende des Hohlzylinders 1 befindet, verbunden.

Die Ablenkdrähte 2 sind parallel zur Primärstrahlungsrichtung 4, die der nicht abgelenkten Strahlungsrichtung des Korpuskularstrahles entspricht, ausgerichtet. Vorsorglich sei hierzu angemerkt, daß die Ausführung der erfindungsgemäßen Ablenkvorrichtung nicht auf Parallelausrichtung der Ablenkdrähten 2 zur Primärstrahlungsrichtung 4 beschränkt ist; es sind auch Ausgestaltungen denkbar, bei denen zumindest einzelne der Ablenkdrähte 2 gegen die Primärstrahlungsrichtung 4 geneigt sind.

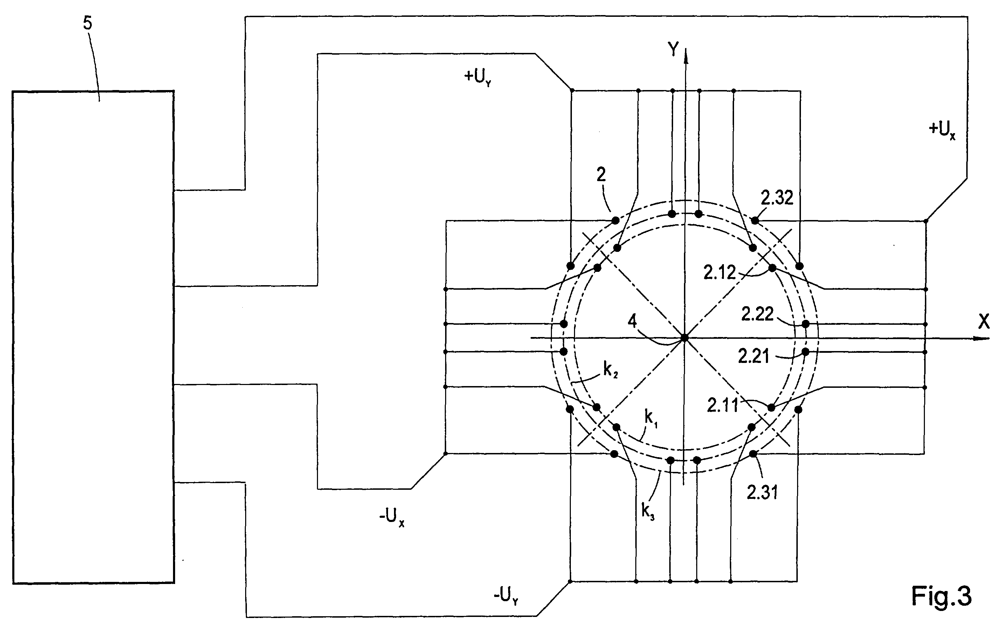

In Fig.3, einer Draufsicht auf den Hohlzylinder 1 aus Fig.2, ist die Positionierung der Ablenkdrähte in Bezug aufeinander sowie relativ zum Ursprung der Koordinaten X und Y, ihre Verknüpfung zu Ablenkgittern sowie ihre Ankopplung an eine Ansteuerschaltung 5 dargestellt. Es ist zu erkennen, daß insgesamt vierundzwanzig Ablenkdrähte 2 vorgesehen sind. Die Ablenkdrähte 2 sind sowohl symmetrisch zur Koordinatenachse X als auch symmetrisch zur Koordinatenachse Y positioniert. Erfindungsgemäß sind die Ablenkdrähte 2 gruppenweise zu Ablenkgittern zusammengefaßt, wobei die zu einunddemselben Ablenkgitter gehörenden Ablenkdrähte 2 unterschiedliche Abstände zum Koordinatenursprung bzw. zu dem nichtabgelenkten Korpuskularstrahl haben, der als Primärstrahlungsrichtung 4 dargestellt ist. So gehören beispielhaft die Ablenkdrähte 2.11, 2.12, 2.21, 2.22, 2.31 und 2.32 zu einem Ablenkgitter, an welches die veränderbare Spannung $+U_X$ gelegt ist.

Die übrigen achtzehn Ablenkdrähte 2 sind zu weiteren drei Gittern zusammengefaßt, wobei zu jedem Gitter wiederum je sechs Ablenkdrähte 2 gehören (die der Übersichtlichkeit halber nicht gesondert mit Bezugzeichen versehen sind) und an die die variierbaren Spannungen $-U_X$, $+U_Y$ und $-U_Y$ gelegt sind.

Das Prinzip der erfindungsgemäßen Vorrichtung wird nun weiter anhand des Gitters mit der anliegenden Spannung $+U_X$ erläutert. Diesbezüglich ist in Fig.3 zu erkennen, daß die Querschnittsmittelpunkte der Ablenkdrähte 2.11, 2.12, 2.21, 2.22, 2.31 und 2.32 auf den Umfangslinien dreier zum Koordinatenursprung bzw. zur Primärstahlungsrichtung 4 konzentrischer Kreise $k_1$, $k_2$ und $k_3$ positioniert sind. Für die Radien dieser Kreise $k_1$, $k_2$, $k_3$ seien Größenverhältnisse von $r_1 : r_2 : r_3 = 1 : 1,1 : 1,21$ angenommen.

Hierzu sei angemerkt, daß der Gegenstand der Erfindung nicht auf die angegebene Anzahl von drei Kreisen beschränkt ist, sondern daß eine hiervon abweichende Anzahl von Kreisen vorgesehen und auch das Verhältnis der Radien dieser Kreise zueinander anderweitig vorgegeben sein kann.

Weiterhin ist aus der Fig.3 ersichtlich, daß dem Kreis $k_1$ zwei Ablenkdrähte 2.11 und 2.12 des Ablenkgitters, an dem die Ablenkspannung $+U_X$ anliegt, zugeordnet sind. Dem Kreis $k_2$ sind zwei Ablenkdrähte 2.21 und 2.22 und dem Kreis $k_3$ zwei Ablenkdrähte 2.31 und 2.32 zugeordnet.

Die Bogenlänge zwischen den Ablenkdrähten 2.11 und 2.12 auf dem Kreis $k_1$, die Bogenlänge zwischen den Ablenkdrähten 2.21 und 2.22 auf dem Kreis $k_2$ und die Bogenlänge zwischen den Ablenkdrähten 2.31 und 2.32 auf dem Kreis $k_3$ verhalten sich zueinander wie etwa 8 : 1 : 14. Dabei kann der Absolutwert der Bogenlänge zwischen den Ablenkdrähten 2.11 und 2.12 im Bereich von 5 mm und 10 mm ausgeführt sein.

Die den übrigen Ablenkgittern zugeordneten Ablenkdrähte 2 sind analog zu dieser Anordnung positioniert. Dabei stehen sich die Ablenkdrähte zweier der Koordinate X zugeordneter Gitter, die mit dem Spannungspotential $\pm U_X$ beaufschlagt sind, symmetrisch zur Koordinatenachse Y gegenüber. Weitere zwei Gitter, die mit dem Spannungspotential $\pm U_Y$ beaufschlagt sind, stehen sich symmetrisch zur Koordinatenachse X gegenüber. So ergibt sich zugleich auch eine Anordnung, bei der die Ablenkgitter jeweils um eine 90°-Drehung gegeneinander versetzt um den nicht abgelenkten Korpuskularstrahl positioniert sind.

Auch diesbezüglich ist darauf hinzuweisen, daß andere Konfigurationen bei der Anordnung der einzelnen Ablenkgitter relativ zum Koordinatenursprung bzw. zu den Koordinatenachsen X und Y denkbar sind. So ist zum Beispiel nicht die Radialsymmetrie bei der Anordnung der vier Ablenkgitter zwingend erforderlich, sondern die jeweils einer Koordinatenachse X oder Y zugeordneten Ablenkgitter können sich voneinander bezüglich der Anzahl der Ablenkdrähte wie auch bezüglich der Positionierung dieser Ablenkdrähte unterscheiden.

Aus Fig.3 geht weiterhin hervor, daß jeweils die Ablenkdrähte 2, die zu einem Ablenkgitter gehören, über Ansteuerleitungen miteinander und mit einem das jeweilige Potential $+U_X$, $-U_X$, $+U_Y$ bzw. $-U_Y$ führenden Ausgang der Ansteuerschaltung 5 verknüpft sind.

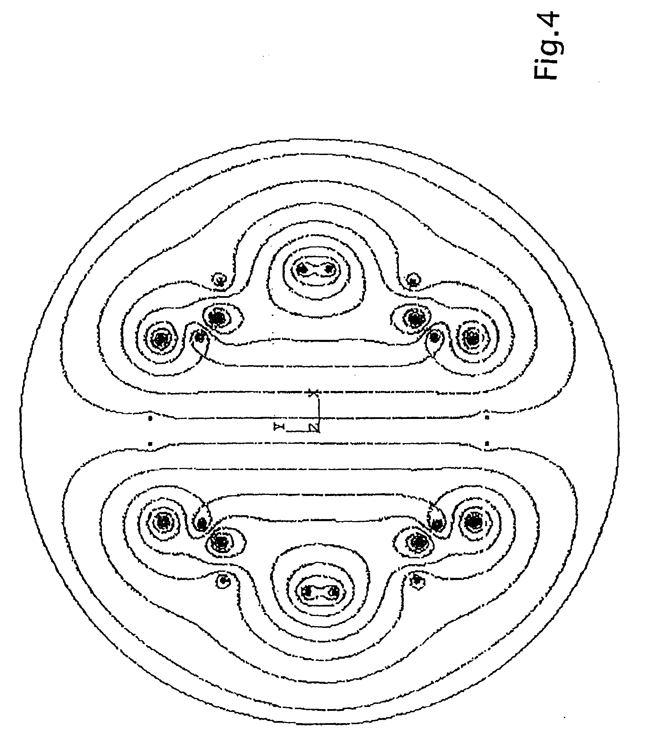

Mit dieser Anordnung wird ein elektrostatisches Feld gemäß Fig.4 erzeugt, wenn beispielsweise an die Ablenkgitter Ansteuerspannungen gelegt sind, die für $\pm U_Y = 0$ und für $\pm U_X$ Werte von $\neq 0$ bis $\pm 100$ Volt ergeben.

In unterschiedlichen Ausgestaltungen der Erfindung können alle Ablenkdrähte einheitlich aus demselben Material, etwa Gold, Platin, Wolfram, Aluminium, Kupfer, Tantal, Titan, Molybdän bzw. Legierungen aus einem oder mehreren der genannten Metalle und Silizium bestehen. Auch können für einzelne Drähte oder Gruppen von Drähten verschiedenen Materialien vorgesehen sein.

Eine besonders bevorzugte Ausgestaltung der Erfindung besteht weiterhin beispielsweise darin, daß die Drähte aus Metallen mit hohem Schmelzpunkt von beispielsweise 1650°C gefertigt sind. Wenn sich bei einer derartigen Anordnung betriebsbedingt Kontaminationsschichten auf den Ablenkdrähten abgesetzt haben, ist es möglich, ohne Schäden für die Drähte eine Reinigung durch Glühen im Vakuum vorzunehmen.

In einer weiteren bevorzugten Ausgestaltung der Erfindung kann vorgesehen sein, daß einzelne oder auch alle Ablenkdrähte durch zugeordnete Federelemente vorgespannt sind, wobei die Federkonstanten der Federelemente so auf die Zugfestigkeit der Drähte abgestimmt sein sollten, daß diese auch unter Betriebsbedingungen nicht reißen. Eine Alternative zur Vorspannung mit Federelementen besteht darin, die Drähte unter Ausnutzung ihrer Eigenelastizität vorzuspannen. Auch hierbei sollte die zulässige Zugspannung unter Betriebsbedingungen nicht überschritten werden.

**Bezugszeichenliste**

| | |
|---|---|
| 1 | Hohlzylinder |
| 2 | Ablenkdrähte |
| 2.11, 2.12 | Ablenkdrahtpaar |
| 2.21, 2.22 | Ablenkdrahtpaar |
| 2.31, 2.32 | Ablenkdrahtpaar |
| 3 | Isolierkörper |
| 4 | Primärstrahlungsrichtung |
| 5 | Ansteuerschaltung |

**Patentansprüche**

1.　Vorrichtung zur elektrostatischen Ablenkung eines Korpuskularstrahles aus einer Primärstrahlungsrichtung zum Zweck der Abtastung einer von zwei Koordinaten X, Y aufgespannten Ebene, bei der mehrere in Form von Ablenkdrähten ausgebildete Elektroden mit einer Ansteuerschaltung verbunden und je nach Ansteuerung mit veränderbaren Ablenkspannungen beaufschlagt sind und die Ablenkspannungen ein Äquivalent für die Ablenkung des Korpukularstrahles aus der Primärstrahlungsrichtung in Richtung der Koordinate X bzw. der Koordinate Y sind, **dadurch gekennzeichnet,** daß mehrere Ablenkdrähte (2) zu Ablenkgittern verknüpft und dabei so miteinander und mit der Ansteuerschaltung (5) verbunden sind, daß bei allen zu einem Ablenkgitter gehörenden Ablenkdrähten (2.11,2.12; 2.21,2.22; 2.31,2.32) stets eine gleichwertige Ablenkspannung anliegt.

2.　Vorrichtung nach Anspruch 1, dadurch gekennzeichnet, daß mehrere Ablenkgitter der Koordinate X zugeordnet und die Ablenkdrähte dieser Ablenkgitter symmetrisch zur Koordinate Y angeordnet sind und/oder daß mehrere Ablenkgitter der Koordinate Y zugeordnet und die Ablenkdrähte dieser Ablenkgitter symmetrisch zur Koordinate X angeordnet sind.

3.　Vorrichtung nach Anspruch 2, dadurch gekennzeichnet, daß der Koordinate X zwei Ablenkgitter zugeordnet sind, wobei zwischen den Ablenkdrähten (2) dieser beiden Ablenkgitter ein Spannungspotential $\pm U_X$ vorgesehen ist und auch der Koordinate Y zwei Ablenkgitter zugeordnet sind, wobei zwischen deren Ablenkdrähten (2) ein Spannungspotential $\pm U_Y$ vorgesehen ist.

4.　Vorrichtung nach einem der vorgenannten Ansprüche, dadurch gekennzeichnet, daß mindestens zwei der zu einunddemselben Ablenkgitter gehörenden Ablenkdrähte (2) in unterschiedlichen Abständen zum Ursprung der Koordinaten X, Y angeordnet sind.

5.　Vorrichtung nach Anspruch 4, dadurch gekennzeichnet, daß die Querschnittsmittelpunkte aller Ablenkdrähte (2) auf Umfangslinien mehrerer zum Koordinatenursprung konzentrisch ausgerichteter Kreise ($k_1, k_2, ... K_n$) verteilt sind.

6.　Vorrichtung nach Anspruch 5, dadurch gekennzeichnet, daß die Ablenkdrähte auf die Umfangslinien dreier Kreise $k_1$, $k_2$, $k_3$ mit den Radien $r_1 < r_2 < r_3$ verteilt sind, wobei jeder der Kreise $k_1$, $k_2$, $k_3$ mit

zwei Ablenkdrähten (2) eines Ablenkgitters besetzt ist.

7. Vorrichtung nach Anspruch 6, dadurch gekennzeichnet, daß das Verhältnis der Radien $r_1 : r_2 : r_3$ etwa 1: 1,1 :1,21 beträgt und sich die Bogenlänge zwischen den Ablenkdrähten (2.11; 2.12) eines Ablenkgitters auf dem Kreis $k_1$, die Bogenlänge zwischen den Ablenkdrähten (2.21; 2.22) eines Ablenkgitters auf dem Kreis $k_2$ und die Bogenlänge zwischen den Ablenkdrähten (2.31; 2.32) eines Ablenkgitters auf dem Kreis $k_3$ zueinander verhalten wie etwa 8 : 1 : 14.

8. Vorrichtung nach Anspruch 7, dadurch gekennzeichnet, daß die Bogenlänge zwischen den Ablenkdrähten (2.11; 2.12) des Ablenkgitters auf dem Kreis $k_1$ zwischen 5 mm und 10 mm beträgt.

9. Vorrichtung nach einem der vorgenannten Ansprüche, dadurch gekennzeichnet, daß die Ablenkspannungen bis ±100V betragen.

Hohlzylinder

Ablenkdrähte

Y

X

Fig.1

Fig.2

Fig.3

Fig.4

EP 1 033 738 A1

**Europäisches Patentamt**

**EUROPÄISCHER RECHERCHENBERICHT**

Nummer der Anmeldung

EP 00 10 0314

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| D,Y | DE 31 38 898 A (SIEMENS AG) 14. April 1983 (1983-04-14) * Seite 4, Zeile 23-34; Abbildungen 1,2 * --- | 1 | H01J3/30 H01J37/147 |
| Y | PATENT ABSTRACTS OF JAPAN vol. 007, no. 058 (E-163), 10. März 1983 (1983-03-10) & JP 57 206172 A (NIPPON DENSHIN DENWA KOSHA), 17. Dezember 1982 (1982-12-17) * Zusammenfassung * --- | 1 | |
| A | "MODULAR ELECTROSTATIC DEFLECTION SYSTEM" IBM TECHNICAL DISCLOSURE BULLETIN,US,IBM CORP. NEW YORK, Bd. 32, Nr. 5B, 1. Oktober 1989 (1989-10-01), Seiten 28-29, XP000049013 ISSN: 0018-8689 --- | | |
| A | US 4 556 823 A (KELLER JOHN H ET AL) 3. Dezember 1985 (1985-12-03) ----- | | |

| RECHERCHIERTE SACHGEBIETE (Int.Cl.7) |
|---|
| H01J |

Der vorliegende Recherchenbericht wurde für alle Patentansprüche erstellt

| Recherchenort | Abschlußdatum der Recherche | Prüfer |
|---|---|---|
| MÜNCHEN | 19. Mai 2000 | Centmayer, F |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
........................................................................
& : Mitglied der gleichen Patentfamilie, übereinstimmendes Dokument

EPO FORM 1503 03.82 (P04C03)

**EP 1 033 738 A1**

**ANHANG ZUM EUROPÄISCHEN RECHERCHENBERICHT
ÜBER DIE EUROPÄISCHE PATENTANMELDUNG NR.**                    EP 00 10 0314

In diesem Anhang sind die Mitglieder der Patentfamilien der im obengenannten europäischen Recherchenbericht angeführten
Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

19-05-2000

| Im Recherchenbericht angeführtes Patentdokument | Datum der Veröffentlichung | Mitglied(er) der Patentfamilie | Datum der Veröffentlichung |
|---|---|---|---|
| DE 3138898 A | 14-04-1983 | KEINE | |
| JP 57206172 A | 17-12-1982 | KEINE | |
| US 4556823 A | 03-12-1985 | DE 3473968 D<br>EP 0132522 A<br>JP 60044951 A | 13-10-1988<br>13-02-1985<br>11-03-1985 |

EPO FORM P0461

Für nähere Einzelheiten zu diesem Anhang : siehe Amtsblatt des Europäischen Patentamts, Nr.12/82

12